# EUROPÄISCHE PATENTANMELDUNG

(11) **EP 2 975 662 A1**
(43) Veröffentlichungstag der Anmeldung: **20.01.2016**
(21) Anmeldenummer: 15176631.8
(22) Anmeldetag: 14.07.2015
(51) Int. Cl.: H01L 41/083, H02N 2/02

(54) **ANORDNUNG UND VERFAHREN ZUM STOSSWELLENGEFÜHRTEN BEWEGEN EINES OBJEKTES**

(30) Priorität: 14.07.2014 DE 102014109849
(71) Anmelder: piezosystem jena GmbH, 07747 Jena (DE)
(72) Erfinder: GÖTZ, Bernt, 07751 Zöllnitz (DE); EBERHARDT, Ramona, 07751 Buch OT Ossmaritz (DE); GEBHARDT, Andreas, 99510 Apolda (DE)
(74) Vertreter: Engel, Christoph Klaus

(57) **Zusammenfassung**

Die vorliegende Erfindung betrifft zunächst eine Anordnung zum stoßwellengeführten Bewegen eines Objektes (01), insbesondere zum Justieren dieses Objektes (01) gegenüber einem als ruhend angesehenen Objekt (03). Die Erfindung betrifft im Weiteren ein Verfahren zum stoßwellengeführten Bewegen eines Objektes (01) mithilfe der erfindungsgemäßen Anordnung. Die erfindungsgemäße Anordnung umfasst einen am zu bewegenden Objekt (01) angepressten Stoßgeber (04), welcher eine Mehrzahl an übereinander angeordneten piezoelektrischen Elementen (06) umfasst. Die Anordnung umfasst weiterhin eine Ansteuerelektronik zum Ansteuern der piezoelektrischen Elemente (06) zur Generierung einer Stoßwelle im Stoßgeber (04).

## Beschreibung

Die vorliegende Erfindung betrifft zunächst eine Anordnung zum stoßwellengeführten Bewegen eines Objektes, insbesondere zum Justieren dieses Objektes gegenüber einem anderen, als ruhend angesehenen Objekt. Die Erfindung betrifft im Weiteren ein Verfahren zum stoßgeführten Bewegen eines Objektes mithilfe der erfindungsgemäßen Anordnung.

Die DE 42 36 795 C1 zeigt einen elektromechanischen Impulsgeber, welcher elektrische Spulen und Schlagstifte umfasst. Durch die elektrische Ansteuerung der Spulen wird der Schlagstift in Richtung einer Halterung ausgelenkt und beschleunigt. Der Schlagstift überträgt beim Aufprall einen mitgeführten mechanischen Impuls auf die Halterung. Die Halterung bildet einen Teil eines zu justierenden Systems. Dieses System ist mechanisch so fixiert, dass eine einwandfreie Funktion der damit verbundenen Baugruppe gewährleistet ist und andererseits eine minimale mechanische Justierung durch die beschriebenen Impulse des Schlagstiftes möglich ist. Nach erfolgter Justierung wird der elektromechanische Impulsgeber wieder abgenommen und kann zur Justierung weiterer Baugruppen verwendet werden. Nachteilig an dieser Lösung ist, dass Reibung an den Lagern des Schlagstiftes auftritt und Partikel generiert werden, die z. B. in Reinraumumgebungen unerwünscht sind. Der einzelne Justierschritt ist stark von der Vorspannung und den gewählten Reibpartnern der Halterung abhängig.

Die DE 602 16 052 T2 lehrt die Erzeugung mechanischer Impulse durch plötzliche Längenänderung eines piezoelektrischen Elements. Das piezoelektrische Element ist als Schlagstift ausgeführt und erzeugt beim Auftreffen auf das zu justierende Objekt einen Impuls. Es ist insbesondere eine Vorrichtung zur Ausrichtung optischer Bauelemente durch vier, acht oder zwölf Schlagstifte beschrieben.

Der wissenschaftliche Artikel von Cermann, C.; Frank, T. und Theska R.: "Positionierung im Sub-Micrometerbereich durch Einleitung mechanischer Impulse"; 50. Internationales Wissenschaftliches Kolloquium, Technische Universität Ilmenau, September 2005, beschreibt die Erzeugung mechanischer Impulse durch eine Schwungmasse, die mittels einer Feder vorgespannt ist. Die Auslenkung erfolgt durch ein Piezostellelement. Wird das Piezostellelement ruckartig verkürzt, wird die Schwungmasse durch die vorgespannte Feder beschleunigt und erzeugt beim Auftreffen auf das zu justierende Objekt einen mechanischen Impuls. Die gesamte Vorrichtung ist an dem zu justierenden Objekt befestigt und bewegt sich während der Justierung mit dem Objekt mit.

Die DE 38 86 260 T2 zeigt eine piezoelektrische Bewegungsvorrichtung mit einem Bewegungselement, an welchem ein piezoelektrisches Element befestigt ist. Das piezoelektrische Element soll eine Schockkraft erzeugen, um das Bewegungselement auf einer Reibungsfläche einer Grundfläche zu bewegen. Am piezoelektrischen Element ist außerdem ein Trägheitselement befestigt. Das Trägheitselement wird durch das piezoelektrische Element bewegt, woraufhin es einen Impuls an das zu justierende Element weitergibt. Ein Nachteil dieser Lösung besteht darin, dass durch die Beendigung der Bewegung ein Rückschwung bewirkt wird. Dieser Rückimpuls kann zu einer gegenläufigen Bewegung des Bewegungselementes führen und damit die Justiergenauigkeit verschlechtern. Ein weiterer Nachteil dieser Lösung besteht darin, dass die Masse des Trägheitselementes und die Masse des Bewegungselementes in einer gleichen Größenordnung liegen müssen, sodass die Resonanzfrequenz des bewegten Systems herabgesetzt ist.

Die JP 2001-242936 A zeigt eine Positioniereinrichtung mit einem piezoelektrischen Element, bei welchem es sich aber nicht um einen Piezoelementstapel handelt. Mit dem einzelnen piezoelektrischen Element kann ein Stoß erzeugt werden, der allerdings nicht stark genug ist, um Justagevorgänge zu ermöglichen.

Die DE 10 2009 028 915 A1 bezieht sich auf die Beschreibung einer elektronischen Ansteuerschaltung. Die Ansteuerung ist für Piezoelemente geeignet. Auf die Art, wie damit eine Bewegung oder gar eine Justage ermöglicht werden könnte, geht diese Druckschrift nicht ein.

Die DE 10 2009 000 022 A1 zeigt den Aufbau von Piezoelementstapeln, liefert aber keinen Hinweis darauf, wie Stoßwellen mithilfe solcher Piezoelementstapel erzeugt und genutzt werden könnten.

Die JP H04-99989 A beschreibt einen Stoßmechanismus, der mit Shape Memory Legierungen (Formgedächtnislegierung) funktioniert. Formgedächtnislegierungen verändern ihre Form durch Temperaturänderungen relativ langsam. Sie könne keine Stoßwellen erzeugen und lassen sich daher nicht zur Stoßjustage verwenden. Weiterhin erreichen sie auch keine hohen Wiederholfrequenzen.

Die JP H11-136979 A zeigt einen Antrieb mit Piezoelementstapeln.

Die Aufgabe der vorliegenden Erfindung besteht ausgehend vom Stand der Technik darin, die durch piezoelektrische Elemente bewirkte Bewegung eines zu bewegenden Objektes auch über längere Strecken mit einer hohen Genauigkeit ausführen zu können. Als "längere Strecken" sind dabei insbesondere Distanzen zu verstehen, die ein Vielfaches, beispielsweise 100-faches oder 1000-faches eines einzelnen Bewegungsschrittes darstellen. Dabei ist eine Teilaufgabe darin zu sehen, dass die Bewegungen in kurzer Zeit ausführbar sind, um z.B. eine Justierung oder Verstellung schnell durchführen zu können.

Die genannte Aufgabe wird gelöst durch eine Anordnung gemäß dem beigefügten Anspruch 1 und durch ein Verfahren gemäß dem beigefügten nebengeordneten Anspruch 10.

Die erfindungsgemäße Anordnung dient dem stoßwellengeführten Bewegen eines Objektes, welches eine Masse m aufweist. Das Bewegen erfolgt durch mindestens eine Stoßwelle, die auf das Objekt wirkt. Bevorzugt wirken nacheinander eine Vielzahl der Stoßwellen auf das Objekt ein. Der durch die erzeugte Stoßwelle generierte Stoß ist zumindest teilweise elastisch, jedoch bevorzugt vollständig elastisch. Die Bewegung des Objektes erfolgt durch den so genannten Stick-Slip-Effekt, welcher auch als Haftgleiteffekt bezeichnet wird. Folglich bedarf es einer Reibung zwischen dem zu bewegenden Objekt und einem als ruhend angesehenen Objekt. Die Reibungskräfte, die bevorzugt durch eine Verspannung zwischen dem zu bewegenden Objekt und dem ruhenden Objekt hergestellt werden, sind insbesondere so groß dimensioniert, dass es nicht aufgrund von Beschleunigungskräften, die im jeweiligen Anwendungsfall üblicherweise auftreten können, zu einer selbsttätigen Verlagerung des zu bewegenden Objektes kommt. Durch die erfindungsgemäße Anordnung lassen sich ausreichend starke Stöße erzeugen, um diese Reibungskräfte zu überwinden und die gewünschte Bewegung des zu bewegenden Objektes zu erreichen. Das Bewegen des Objektes dient bevorzugt zum Justieren dieses Objektes. Das zu bewegende Objekt stellt bevorzugt einen Bestandteil der erfindungsgemäßen Anordnung dar.

Zum besseren Verständnis des oben bereits erwähnten stick-slip-Effekts: In einem ersten Schritt wird das zu bewegende Objekt zunächst schnell weggestoßen. Dabei werden die Reibungskräfte zwischen dem zu bewegenden Objekt und der unbewegter Unterlage überwunden. Im nachfolgenden Schritt findet eine langsame entgegengesetzte Bewegung statt. Das zu bewegende Objekt wird zusammen mit Unterlage wieder "herangezogen", um erneut in den Bewegungsbereich des Stoßantriebes zu gelangen. Die Positionierung mithilfe des stick-slip-Effekts ermöglicht auch eine Justage über den originären Bewegungsbereich des Antriebes / des Piezoelementes / des Stoßantriebes hinaus durch die zusammengesetzte Bewegung: Wegstoßen und danach Heranziehen. Die dabei zwangsweise notwendige langsame Bewegung ist prinzipbedingt notwendig und verhindert aber genauso prinzipiell eine hohe Wiederholrate der Stoßjustage bei Lösungen nach dem Stand der Technik. Der stick-slip-Effekt wird im Stand der Technik gelegentlich zur Positionierung eingesetzt, ist aber dort ein langsamer Vorgang mit geringen Kräften.

Die erfindungsgemäße Anordnung umfasst einen am zu bewegenden Objekt vorzugsweise elastisch befestigten Stoßgeber, mit welchem der mindestens eine Stoß auf das Objekt bewirkt wird. Der Stoßgeber umfasst eine Mehrzahl an übereinander angeordneten piezoelektrischen Elementen in Form eines Piezoelementestapels (mechanische Reihenschaltung), mit denen ein mechanischer Impuls erzeugbar ist, welcher zu einer im Stoßgeber sich ausbreitenden Stoßwelle und damit zu dem gewünschten Stoß führt, welcher dem zu bewegenden Objekt eingeprägt wird. Durch Anlegen einer elektrischen Spannung an die piezoelektrischen Elemente dehnen diese sich aus, wobei die Masse der piezoelektrischen Elemente und die Geschwindigkeit des Ausdehnens letztlich den zu erzeugenden Impuls bestimmen. Die piezoelektrischen Elemente im Stapel sind dabei über entsprechende Elektroden elektrisch parallel geschaltet und werden gleichzeitig elektrisch angesteuert.

Die erfindungsgemäße Anordnung umfasst weiterhin eine Ansteuerelektronik zum elektrisch parallelen Ansteuern der mechanisch in Reihe liegenden piezoelektrischen Elemente zur Generierung einer Stoßwelle im Stoßgeber. Die mechanischen Impulse der einzelnen mechanisch in Reihe angeordneten piezoelektrischen Elemente führen in ihrer Summe zu einer Stoßwelle, die sich im Stoßgeber, d. h. in dem Stapel der in Reihe angeordneten piezoelektrischen Elemente ausbreitet. Am Übergang vom Stoßgeber zu dem zu bewegenden Objekt besteht eine mechanisch starre Verbindung, beispielsweise über einen Stößel, sodass die sich mit einer Geschwindigkeit von einigen m/s ausbreitende Stoßwelle einen Stoß zwischen auf das Objekt bewirkt. Dabei wird aber bevorzugt auf eine freie Bewegung des Stößels verzichtet, da ein "Anschlagen" des Stößels am zu bewegenden Objekt für die Übertragung der Stoßwelle nicht erforderlich ist und stattdessen nur zu einem unerwünschten Verschleiß führen würde. Aufgrund des Impulserhaltungssatzes und des Energieerhaltungssatzes bewegt sich das zu bewegende Objekt, wobei diese Bewegung wegen der Reibung zwischen dem zu bewegenden Objekt und dem als ruhend angesehenen Objekt nach einer kurzen Wegstrecke wieder endet, insofern keine weiteren Stöße erzeugt werden.

Erfindungsgemäß ist der Stoßgeber von dem zu bewegenden Objekt gehalten, wofür eine Anpresskraft in Längsrichtung des Piezoelementestapels auf den Stoßgeber einwirkt, um diesen gegen das zu bewegende Objekt zu pressen. Die Anpresskraft ist so gewählt, dass eine hinreichende Festigkeit der Verbindung zwischen dem Stoßgeber und dem zu bewegenden Objekt erhalten bleibt, die eine Übertragung des Stoßes gestattet. Die Anpresskraft muss dafür auf die vom Piezoelementestapel erzeugbare Kraft abgestimmt sein. Bevorzugt ist der Stoßgeber vollständig von dem zu bewegenden Objekt gehalten. Bevorzugt ist der Stoßgeber ausschließlich mit dem zu bewegenden Objekt mechanisch verbunden, d. h. es besteht keine mechanische Verbindung von dem Stoßgeber zu dem als ruhend angesehenen Objekt außer derjenigen über das zu bewegende Objekt. Hierfür ist der Stoßgeber bevorzugt an dem zu bewegenden Objekt befestigt, wobei diese Befestigung elastisch ist, vorzugsweise durch Anpressen des Stoßgebers am zu bewegenden Objekt mit einer Federkraft. Bevorzugt ist die Befestigung so ausgebildet, dass ausschließlich ein Freiheitsgrad des Stoßgebers gegenüber dem zu bewegenden Objekt verbleibt, nämlich der Freiheitsgrad für eine Längenänderung des Stoßgebers aufgrund des piezoelektrischen Effektes. Da der Stoßgeber von dem zu bewegenden Objekt gehalten ist, bewegt sich der Stoßgeber gemeinsam mit dem zu bewegenden Objekt. Somit kann der Stoßgeber immer wieder Stoßwellen dem zu bewegenden Objekt einprägen, wenngleich die durch den piezoelektrischen Effekt bedingte Längenänderung des Stoßgebers sehr klein ist. Folglich kann das zu bewegende Objekt trotz dieser sehr kleinen Längenänderung nahezu beliebig weit bewegt werden.

Erfindungsgemäß ist das Piezoelement (Stoßergeber) durch eine Andruckkraft (Vorspannung) mit dem zu bewegenden Objekt verbunden. Anders als bei der im Stand der Technik bekannten Nutzung des stick-slip-Effekts wandert der Stoßgeber bei der erfindungsgemäßen Anordnung währende der Justage mit dem zu bewegenden Objekt mit. Der langsame Schritt des Zurückziehens (wie beim herkömmlichen stick-slip-Effekt) ist damit prinzipiell gemäß der Erfindung nicht mehr notwendig.

Ein besonderer Vorteil der erfindungsgemäßen Anordnung besteht darin, dass sie keiner Trägheitsmasse bedarf, wenngleich eine solche optional verwendet werden kann. Im einfachsten Fall besteht der Stoßgeber ausschließlich aus den piezoelektrischen Elementen und ggf. deren elektrischen Anschlüssen. Auf eine separate Trägheitsmasse, die im Stand der Technik regelmäßig nötig ist, wird bei der bevorzugten Ausführungsform somit verzichtet. Bei einer nochmals abgewandelten Ausführung besitzt die Anordnung sowie ggf. einem Stößel.

Insbesondere bei Ausführungsformen ohne Trägheitsmasse wird damit eine wesentlich höhere Dynamik erreicht. Die Stoßenergie wird aus der Dynamik des Piezoelementstapels gewonnen und nicht aus der Beschleunigung einer trägen (also langsamen) Masse. Ohne träge Masse können die Piezoelemente Anstiegszeiten erreichen, die schneller als die Resonanzfrequenz sind.

In diesem Sinne wird hier unter einer "Trägheitsmasse" die Masse eines Körpers verstanden, der zusätzlich an dem Piezoelement befestigt ist, absolut passiv ist und nur die (träge) Masse des Stoßgebers vergrößert. Demgegenüber hat das Piezoelement selber natürlich auch eine Masse, die aber nicht nur passiv wirkt sondern dem den Stoß erzeugenden Antriebselement zuzurechnen ist.

Der erfindungsgemäße Aufbau der Anordnung, wenn sie auf eine Trägheitsmasse verzichtet, ermöglicht eine sehr schnelle

Ansteuerung mit Frequenzen bis weit oberhalb der Resonanzfrequenz. Dadurch können sehr schnelle Stoßwellen erzeugt werden und somit sehr hohe Stoßimpulse. Bei Anordnungen gemäß dem Stand der Technik, die eine Trägheitsmasse benötigen, wird hingegen durch die Trägheitsmasse die Resonanzfrequenz stark herabgesetzt, schnelle Stoßimpulse sind daher nicht möglich.

In einer abgewandelten Ausführungsform umfasst die erfindungsgemäße Anordnung eine zusätzliche am Stoßgeber angebrachte Trägheitsmasse, die in Stoßrichtung dem zu bewegenden Objekt gegenüber liegt, sodass sich der Piezoelementstapel zwischen der Trägheitsmasse und dem zu bewegenden Objekt befindet. Die Trägheitsmasse nimmt den Rück-Impuls des Piezostoßes auf. Der Impuls wird an der Trägheitsmasse reflektiert und breitet sich genauso, nur mit einer Zeitverzögerung im Piezoelementstapel aus und wird letztendlich ebenfalls wie der primäre vorwärtsgerichtete Impuls auf das zu bewegende Objekt übertragen. Durch die Verwendung einer Trägheitsmasse kann der Energieeintrag auf das zu bewegende Objekt vergrößert werden.

Bei bevorzugten Ausführungsformen der erfindungsgemäßen Anordnung sind die mehreren piezoelektrischen Elemente in einer Bewegungsrichtung übereinander, d. h. mechanisch in Reihe angeordnet. Somit entspricht die Stapelrichtung der Bewegungsrichtung. Wird an die piezoelektrischen Elemente eine elektrische Spannung angelegt, so dehnen diese sich in der Bewegungsrichtung aus. Gleichzeitig ziehen sich die Piezoelemente in Querrichtung zusammen, was hier aber hier keine Rolle spielt. Da die elektrische Spannung gleichzeitig über Metallelektroden an alle Keramikscheiben der Piezoelemente zugeschaltet wird, dehnen sich alle Keramikscheiben gleichzeitig aus. In diesem Metall-Keramik-Verbund wird also über die gesamte Länge gleichzeitig ein Impuls aufgebaut und eine Stoßwelle erzeugt.

Folglich wird ein mechanischer Impuls in die Bewegungsrichtung erzeugt, sodass das zu bewegende Objekt in die Bewegungsrichtung bewegt wird.

Bevorzugt ist das Piezoelement aus diskreten Keramikscheiben und zwischenliegenden Metallelektroden zusammengesetzt. Dieser Stapelaufbau wird durch eine externe Feder sehr stark vorgespannt, sodass die Vorspannung auftretende Zugkräfte (durch die Dynamik und Beschleunigung) übertrifft. Als Ergebnis kann der Stapelaufbau mit sehr kurzen Spannungsimpulsen angesteuert werden und Stoßzeiten generieren, die schneller sind als die, die seiner Anstiegszeit entsprächen.

Bevorzugt ist eine in die Bewegungsrichtung gerichtete Oberfläche des Stoßgebers auf das zu bewegende Objekt gepresst, sodass der durch die piezoelektrischen Elemente erzeugbare mechanische Impuls weitestgehend vollständig als Stoß auf das zu bewegende Objekt wirken kann. Bei der in die Bewegungsrichtung gerichteten Oberfläche des Stoßgebers handelt es sich im einfachsten Fall unmittelbar um die Oberfläche des obersten piezoelektrischen Elementes des Stoßgebers oder bevorzugt um einen starren Stößel, beispielsweise aus Stahl oder Titan.

Der Stoßgeber ist mit seiner in die Bewegungsrichtung gerichteten Oberfläche bzw. vermittelt über den Stößel bevorzugt mit einer Andruckfeder auf das zu bewegende Objekt gepresst. Die Andruckfeder ist von einem an dem zu bewegenden Objekt befestigten Federhalter gehalten. Bevorzugt ist der Stoßgeber mit der Andruckfeder zwischen dem zu bewegenden Objekt und dem Federhalter eingespannt.

Bei besonderen Ausführungsformen der erfindungsgemäßen Anordnung ist auf der in die Bewegungsrichtung gerichteten Oberfläche des Stoßgebers ein Stößel befestigt, über welchen die Andruckfeder den Stoßgeber gegen das zu bewegende Objekt presst. Der Stößel kann beispielsweise die Form eines Stabes aufweisen, wobei auch andere Formen gewählt werden können.

Zum Schutz des Piezoelementstapels vor zu großen Zugkräften auf die piezoelektrischen Elemente, wird der Piezoelementstapel bevorzugt vorgespannt, beispielsweise durch eine Vorspannfeder, die den Piezoelementstapel zusammenpresst.

Bei alternativen bevorzugten Ausführungsformen ist die in die Bewegungsrichtung gerichtete Oberfläche des Stoßgebers durch eine Klebeverbindung auf das zu bewegende Objekt gepresst. Folglich wird der Stoßgeber durch die Klebeverbindung an dem zu bewegenden Objekt gehalten, wenngleich die Anpresskraft der Andruckfeder weiterhin auf den Stoßgeber wirkt.

Grundsätzlich können auch andere Befestigungs- bzw. Haltemittel gewählt werden, um den Stoßgeber an dem zu bewegenden Objekt anzubringen, solange sie ein Einprägen der Stoßwelle auf das zu bewegenden Objekt zulassen.

Bei bevorzugten Ausführungsformen der erfindungsgemäßen Anordnung ist das zu bewegende Objekt auf einer Grundfläche angeordnet, auf der es bewegbar ist. Somit bildet die Grundfläche das als ruhend angesehene Objekt. Zwischen der Grundfläche und dem zu bewegenden Objekt tritt eine Reibung auf, insbesondere treten eine Haftreibung und eine Gleitreibung auf. Das zu bewegende Objekt ist insbesondere auf der Grundfläche verschiebbar. Die Bewegungsrichtung ist somit bevorzugt parallel zur Grundfläche ausgerichtet.

Bei einfachen Ausführungsformen der erfindungsgemäßen Anordnung ist das Objekt durch seine Schwerkraft gegen die Grundfläche gepresst; insbesondere wenn sich die Anordnung auf der Erde befindet und die Grundfläche horizontal angeordnet ist.

Bei bevorzugten Ausführungsformen der erfindungsgemäßen Anordnung ist das Objekt durch eine Haltefeder gegen die Grundfläche gepresst; insbesondere wenn sich die Anordnung in der Schwerelosigkeit befindet oder wenn die Grundfläche nicht horizontal angeordnet ist. Beispielsweise eignet sich die Anordnung zum Betrieb innerhalb von Satelliten in der Schwerelosigkeit. Die Haltefeder ist bevorzugt dazu ausgebildet, das zu bewegende Objekt mit einer konstanten Kraft gegen die Grundfläche zu pressen, nämlich unabhängig von der Position des zu bewegenden Objektes auf der Grundfläche.

Bevorzugt sind die Piezoelemente des Stoßgebers in einem Gehäuse angeordnet, welches die axiale Ausdehnung der Piezoelemente gestattet und vorzugsweise auch die Vorspannfeder zum mechanischen Vorspannen des Piezoelementstapels aufnimmt. Die Andruckfeder zum Anpressen des Stoßgebers am zu bewegenden Objekt greift vorzugsweise am Gehäuse an, sodass die Federkraft vorzugsweise auf die dem zu bewegenden Objekt diametral gegenüberliegende Rückseite des Piezoelementstapels einwirkt.

Der Stoßgeber ist bevorzugt an einer Seitenfläche des zu bewegenden Objektes angeordnet, sodass seitliche Stöße durch den Stoßgeber auf das zu bewegende Objekt übertragen werden, wodurch sich das Objekt zur Seite bewegt, insbesondere für eine Verschiebung auf der Grundfläche.

Bei bevorzugten Ausführungsformen der erfindungsgemäßen Anordnung sind mehrere der Stoßgeber an dem zu bewegenden Objekt angebracht. Besonders bevorzugt sind zwei der Stoßgeber an jeweils zwei senkrecht zueinander angeordneten Seitenflächen des zu bewegenden Objektes angeordnet. Somit sind die Bewegungsrichtungen der beiden Stoßgeber senkrecht zueinander ausgerichtet, sodass das Objekt entsprechend den kartesischen Koordinaten auf der Grundfläche verschoben werden kann. Bei weiteren bevorzugten Ausführungsformen sind zwei der Stoßgeber an jeweils zwei gegenüberliegenden angeordneten Seitenflächen des zu bewegenden Objektes angeordnet, sodass das Objekt in dieser Bewegungsrichtung vorwärts und rückwärts bewegt werden kann.

Die piezoelektrischen Elemente sind bevorzugt elektrisch parallel zusammengeschaltet, sodass keine hohen elektrischen Spannungen für deren Betrieb notwendig sind.

Die piezoelektrischen Elemente bestehen bevorzugt aus einer piezoelektrischen Keramik, welche durch die erzeugten Stoßwellen nicht beschädigt werden kann, und Metallelektroden, über welche die Betriebsspannung angelegt wird.

Bei dem zu bewegenden Objekt kann es sich um ein beliebiges zu bewegendes bzw. zu justierendes Objekt handeln, beispielsweise um einen Spiegel eines optischen Teleskops, welches im Weltall betrieben wird. Die erfindungsgemäße Anordnung kann in der Schwerelosigkeit und auch im Vakuum betrieben werden.

Das erfindungsgemäße Verfahren dient zum stoßwellengeführten Bewegen eines Objektes mithilfe der erfindungsgemäßen Anordnung. Gemäß dem Verfahren werden die piezoelektrischen Elemente durch die Ansteuerelektronik mit mindestens einem elektrischen Impuls beaufschlagt, um eine Längenänderung des Stoßgebers zu bewirken, wodurch dem zu bewegenden Objekt ein Stoß eingeprägt wird. Durch den Stoß wird ein mechanischer Impuls auf das zu bewegende Objekt übertragen, wodurch die Haftreibung zwischen dem zu bewegenden Objekt und einem als ruhend angesehenen Objekt überwunden wird. Dadurch bewegt sich das Objekt eine kleine Wegstrecke, wobei es seine kinetische Energie aufgrund der Gleitreibung zwischen dem zu bewegenden Objekt und dem als ruhend angesehenen Objekt verliert und alsbald zum Stillstand kommt. Das Objekt wird durch die Haftreibung im Stillstand gehalten.

Das erfindungsgemäße Verfahren wird bevorzugt für die o.g. bevorzugten Ausführungsformen der erfindungsgemäßen Anordnung verwendet.

Da die piezoelektrischen Elemente auch als Sensoren betrieben werden können, ist die Ansteuerelektronik bevorzugt dazu konfiguriert, die piezoelektrischen Elemente alternativ als Sensor zu betreiben, um externe Stöße auf die Anordnung zu messen.

Bei bevorzugten Ausführungsformen des erfindungsgemäßen Verfahrens werden die piezoelektrischen Elemente gleichzeitig mit dem mindestens einen elektrischen Impuls beaufschlagt.

Das Objekt wird infolge der Beaufschlagung mit dem Impuls nur eine sehr kurze Wegstrecke bewegt, da sich die piezoelektrischen Elemente nur geringfügig ausdehnen. Daher werden die piezoelektrischen Elemente bevorzugt mit einer Folge der elektrischen Impulse beaufschlagt. Die Impulsfolge weist eine Wiederholfrequenz auf, die recht groß sein kann, nämlich bevorzugt im Bereich zwischen 100 Hz und 10 kHz.

Das erfindungsgemäße Verfahren umfasst bevorzugt einen Schritt, bei welchem zunächst eine Anzahl an erforderlichen Stößen zum Zurücklegen eines vom Objekt zurückzulegenden Weges bestimmt wird. Hierfür ist der zurückzulegende Weg durch die je Stoß zurücklegbare Wegstrecke zu teilen. Anschließend sind die piezoelektrischen Elemente durch die Ansteuerelektronik mit einer Anzahl der elektrischen Impulse entsprechend der bestimmten Anzahl an erforderlichen Stößen zu beaufschlagen. Dieses vorhergehende Festlegen der Anzahl an erforderlichen Stößen ist deswegen möglich, weil die erfindungsgemäße Anordnung das zu bewegende Objekt um eine sehr genau bestimmbare Wegstrecke je Stoß bewegt.

Gemäß einer bevorzugten Ausführungsform wird vor dem Anlegen der den Impuls erzeugenden Betriebsspannung eine dazu negative Spannung an die Piezoelemente angelegt. Damit zieht sich die Keramik zunächst zusammen. Das vergrößert beim unmittelbar nachfolgenden Anlegen der Betriebsspannung den Hub.

Bei einer bevorzugten Ausführungsform der Erfindung kann die Schrittweite, die vom Stoßgeber ausgelöst wird, in einem weiten Bereich variiert werden (nm bis µm Schrittweite) durch Variation der Steuerspannung, die an die Piezoelement angelegt wird. Damit lässt sich die Verfahrgeschwindigkeit des zu bewegenden Objektes variieren und insbesondere eine hohe Justagegeschwindigkeit erreichen.

Weitere Vorteile, Einzelheiten und Weiterbildungen der Erfindung ergeben sich aus der nachfolgenden Beschreibung bevorzugter Ausführungsformen der Erfindung, unter Bezugnahme auf die Zeichnung. Es zeigen:
- Fig. 1:: eine perspektivische Ansicht einer bevorzugten Ausführungsform einer erfindungsgemäßen Anordnung;
- Fig. 2:: eine Querschnittsansicht einer weiteren Ausführungsform der erfindungsgemäßen Anordnung;
- Fig. 3:: eine alternative Anbringung des in Fig. 1 gezeigten Stoßgebers;
- Fig. 4:: eine weitere bevorzugte Anbringung des in Fig. 1 gezeigten Stoßgebers;
- Fig. 5: eine Detailansicht des Stoßgebers in einer vereinfachten Längsschnittansicht.

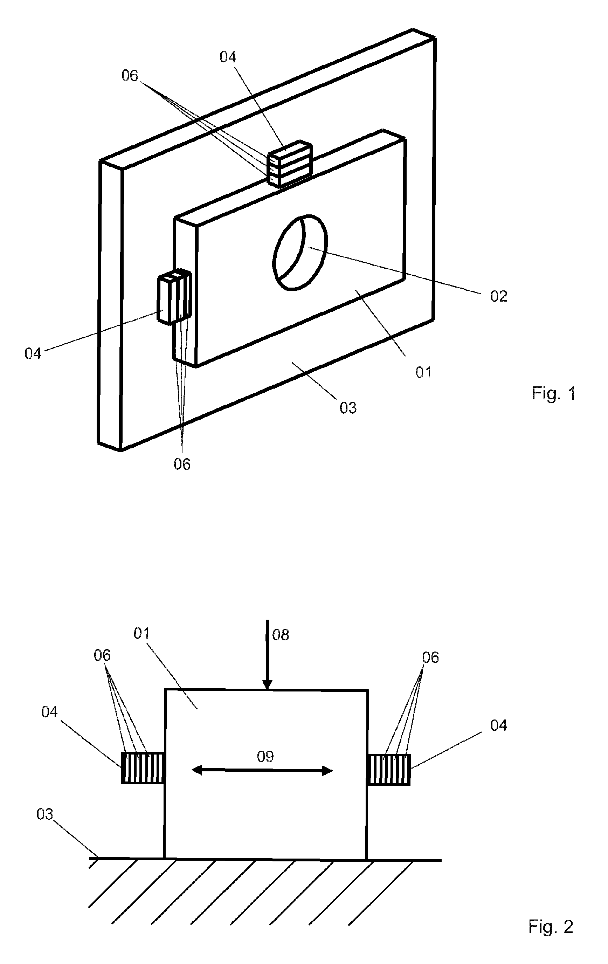

Fig. 1 zeigt in starker Vereinfachung eine perspektivische Ansicht einer bevorzugten Ausführungsform einer erfindungsgemäßen Anordnung zum stoßwellengeführten Bewegen eines zu bewegenden Objektes 01. Das beispielhaft gezeigte Objekt 01 trägt beispielhaft einen Spiegel 02, welcher auf einer als ruhend anzusehenden Grundfläche 03 zu justieren ist. Das zu bewegende Objekt 01 ist mit einer Haltefeder (nicht gezeigt) gegen die Grundfläche 03 gepresst, sodass eine Haftreibung und eine Gleitreibung zwischen dem zu bewegenden Objekt 01 und der Grundfläche 03 auftreten. Die Anordnung kann daher auch in der Schwerelosigkeit betrieben werden.

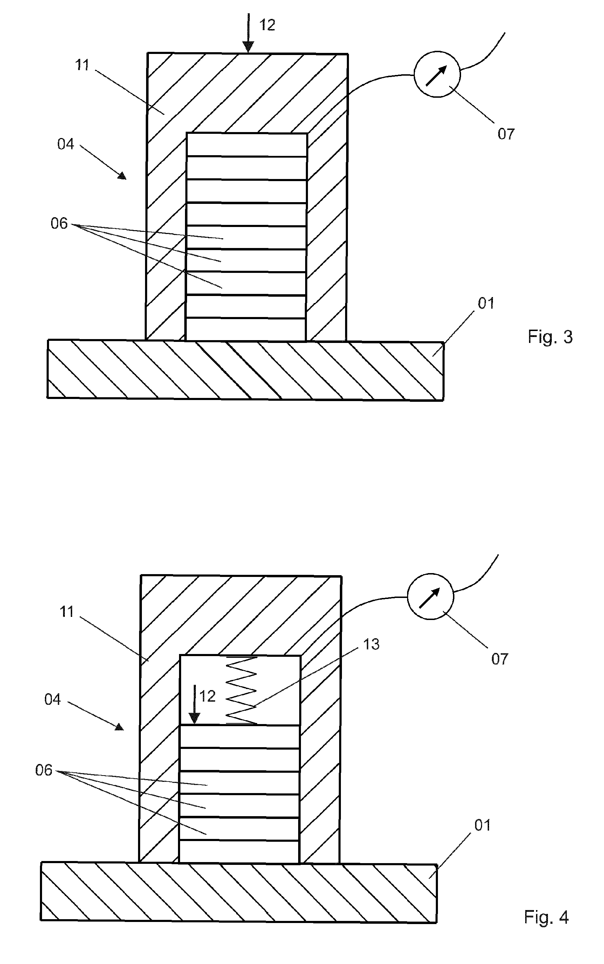

An zwei zueinander senkrecht angeordneten Seitenflächen des zu bewegenden Objektes 01 ist jeweils ein Stoßgeber 04 angebracht, welcher aus einer Mehrzahl mechanisch in Reihe geschalteter piezoelektrischer Elemente 06 besteht. Die piezoelektrischen Elemente 06 sind durch eine Ansteuerelektronik 07 (gezeigt in Fig. 3) mit elektrischen Impulsen beaufschlagbar. Bei der gezeigten Ausführungsform sind die Stoßgeber 04 an das zu bewegende Objekt 01 angeklebt, wobei die Klebeverbindungen ein Übertragen einer im Stoßgeber 04 erzeugten Stoßwelle zulassen. Das Einwirken der Stoßwelle auf das Objekt 01 führt dazu, dass es gegenüber der Grundfläche 03 bewegt wird.

Fig. 2 zeigt eine Querschnittsansicht einer weiteren Ausführungsform der erfindungsgemäßen Anordnung. Diese Ausführungsform gleich zunächst der in Fig. 1 gezeigten Ausführungsform. Das Objekt 01 wird durch die Haltefeder (nicht gezeigt) mit einer in eine Richtung 08 wirkenden Haltekraft auf die Grundfläche 03 gepresst. Im Gegensatz zu der in Fig. 1 gezeigten Ausführungsform umfasst die Anordnung zwei der Stoßgeber 04, die an gegenüberliegenden Seiten des Objektes 01 angeordnet sind, sodass das Objekt 01 in einer Bewegungsrichtung 09 vorwärts und rückwärts bewegt werden kann.

Fig. 3 zeigt eine alternativ bevorzugte Anbringung des Stoßgebers 04 am Objekt 01. Statt einer Klebeverbindung ist der Stoßgeber 04 mit einem am Objekt 01 befestigten U-förmigen Gehäuse 11 am Objekt 01 angebracht. Auf das Gehäuse 11 wirkt eine Anpresskraft 12, die auf die dem zu bewegenden Objekt gegenüberliegende Seite des Stapels aus den piezoelektrischen Elementen 06 übertragen wird, sodass der Stoßgeber 04 an das Objekt 01 gepresst ist.

Fig. 4 zeigt eine weitere bevorzugte Anbringung des Stoßgebers 04 am Objekt 01. Diese Anbringung gleicht zunächst der in Fig. 3 gezeigten Anbringung des Stoßgebers 04 am Objekt 01. Zusätzlich ist im U-förmigen Gehäuse 11 eine Andruckfeder 13 angeordnet, durch welche die Andruckkraft 12 bereitgestellt wird und der Stapel aus piezoelektrischen Elementen 06 an das Objekt 01 gepresst ist.

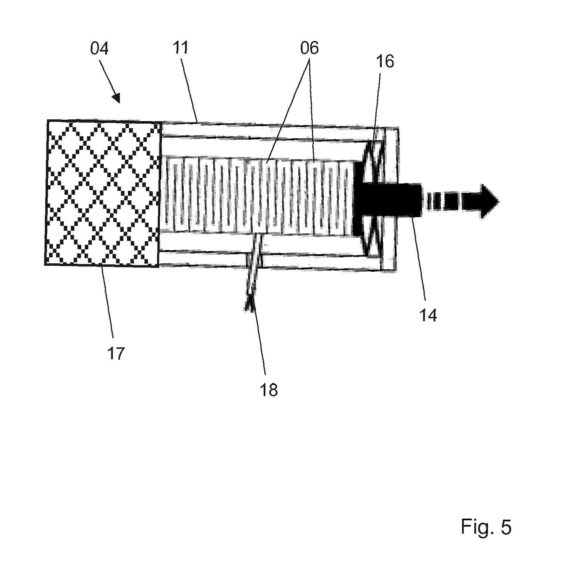

Fig. 5 zeigt eine vereinfachte Längsschnittansicht des Stoßgebers 04 ohne die Anbindung an das zu bewegende Objekt. Es ist erkennbar, dass die piezoelektrischen Elemente 06 als Stapel innerhalb des Gehäuses 11 unter Belassung eines Spalts zur Gehäusewand angeordnet sind, um die Ausdehnung des Piezoelementestapels in Längsrichtung nicht zu behindern. Auf der zu dem zu bewegenden Objekt gerichteten Seite ist ein Stößel 14 an den Piezoelementestapel angeschlossen, der die im Stapel erzeugte Stoßwelle an das zu bewegende Objekt überträgt. Nach dem Anbau des Stoßgebers 04 an das zu bewegende Objekt verbleibt zwischen dem Stößel 14 und dem Objekt vorzugsweise kein Spalt, sodass mechanischer Verschleiß am Stößel vermieden wird.

Weiterhin ist bei der in Fig. 5 gezeigten Ausführungsform innerhalb des Gehäuses 11 eine Vorspannfeder 16 angeordnet, die eine Vorspannkraft auf den Piezoelementestapel ausübt. Die Vorspannfeder 16 ist beispielsweise eine Tellerfeder, die zwischen der Innenwand der Gehäuses 11 und dem Piezoelementestapel eingespannt ist. Die Vorspannung verhindert bei hochfrequenter Ansteuerung der piezoelektrischen Elemente 06 eine sonst drohende Zerstörung des Stapels. Alternativ dazu könnte die elektrische Ansteuerung aber auch mit einer angepassten oder modulierten Betriebsfrequenz erfolgen, um die im Stapel auftretenden Kräfte nicht zu groß werden zu lassen.

Die in Fig. 5 gezeigte Ausführung verwendet darüber hinaus eine Trägheitsmasse 17, die an der dem Stößel 14 und dem zu bewegenden Objekt gegenüberliegenden Seite des Stapels der piezoelektrischen Elemente 06 angebracht ist. Die Trägheitsmasse spiegelt den in diese Richtung auftretenden Impuls und lenkt diesen in Richtung zu dem zu bewegenden Objekt. Schließlich ist noch ein elektrischen Anschluss 18 gezeigt, über welchen die piezoelektrischen Elemente 06 mit der Betriebsspannung versorgt werden.

### Bezugszeichenliste

- 01: zu bewegendes Objekt
- 02: Spiegel
- 03: Grundfläche
- 04: Stoßgeber
- 05: -
- 06: piezoelektrisches Element
- 07: Ansteuerelektronik
- 08: Richtung
- 09: Bewegungsrichtung
- 10: -
- 11: Gehäuse
- 12: Andruckkraft
- 13: Andruckfeder
- 14: Stößel
- 15: -
- 16: Vorspannfeder
- 17: Trägheitsmasse
- 18: elektrischer Anschluss

## Patentansprüche

1. Anordnung zum stoßwellengeführten Bewegen eines Objektes (01), mit einem Stoßgeber (04), welcher eine Mehrzahl piezoelektrischer Elemente (06) umfasst, die mechanisch in Reihe geschaltet einen Piezoelementestapel bilden; und mit einer Ansteuerelektronik (07) zum Ansteuern der piezoelektrischen Elemente (06) zur Generierung einer Stoßwelle, die sich entlang der Längsachse des Piezoelementestapels im Stoßgeber (04) ausbreitet; wobei der Stoßgeber (04) zur Befestigung am zu bewegenden Objekt (01) mit einer entlang der Längsachse des Piezoelementestapels wirkenden Anpresskraft (12) an das zu bewegende Objekt (01) angepresst wird.

2. Anordnung nach Anspruch 1, **dadurch gekennzeichnet, dass** die mehreren piezoelektrischen Elemente (06) in einer Bewegungsrichtung (09) übereinander angeordnet sind, sodass die Längsachse des Piezoelementestapels parallel zur Bewegungsrichtung (09) verläuft.

3. Anordnung nach Anspruch 1 oder 2, **dadurch gekennzeichnet, dass** sie außer dem Piezoelementstapel keine eigenständige Trägheitsmasse umfasst.

4. Anordnung nach Anspruch 2 oder 3, **dadurch gekennzeichnet, dass** eine in die Bewegungsrichtung (09) gerichtete Oberfläche des Stoßgebers (04) auf das zu bewegende Objekt (01) gepresst ist.

5. Anordnung nach Anspruch 4, **dadurch gekennzeichnet, dass** die in die Bewegungsrichtung (09) gerichtete Oberfläche des Stoßgebers (04) mit einer Andruckfeder (13) auf das zu bewegende Objekt (01) gepresst ist, wobei die Andruckfeder (13) von einem an dem zu bewegenden Objekt (01) befestigten Gehäuse (11) gehalten ist.

6. Anordnung nach einem der Ansprüche 1 bis 5, **dadurch gekennzeichnet, dass** jeweils ein oder mehrere Stoßgeber (04) an zueinander winklig angeordneten Seitenflächen des zu bewegenden Objektes (01) angeordnet sind.

7. Anordnung nach einem der Ansprüche 1 bis 6, **dadurch gekennzeichnet, dass** das zu bewegende Objekt (01) auf einer Grundfläche (03) angeordnet ist, auf der es bewegbar ist.

8. Anordnung nach Anspruch 7, **dadurch gekennzeichnet, dass** das zu bewegende Objekt (01) durch seine Schwerkraft gegen die Grundfläche (03) gepresst ist.

9. Anordnung nach Anspruch 7 oder 8, **dadurch gekennzeichnet, dass** das Objekt (01) durch eine Haltefeder gegen die Grundfläche (03) gepresst ist.

10. Verfahren zum stoßwellengeführten Bewegen eines Objektes (01) durch eine Anordnung nach einem der Ansprüche 1 bis 9, umfassend einen Schritt, bei welchem die mehreren piezoelektrischen Elemente (06) zeitlich gleichzeitig durch die Ansteuerelektronik (07) mit einem elektrischen Impuls beaufschlagt werden, um eine sich im Stoßgeber (04) linear ausbreitende mechanische Impulswelle zu erzeugen.

11. Verfahren nach Anspruch 10, **dadurch gekennzeichnet, dass** die elektrischen Impulse eine Wiederholfrequenz zwischen 100 Hz und lOkHz aufweisen.
